# EUROPEAN PATENT APPLICATION

(11) **EP 4 576 954 A1**
(43) Date of publication of application: **25.06.2025**
(21) Application number: 23856114.6
(22) Date of filing: 27.04.2023
(51) Int. Cl.: H05K 5/02, G02B 30/27, G09F 3/02

(54) **OPTICAL STRUCTURE, TERMINAL HOUSING AND TERMINAL**

(30) Priority: 25.08.2022 CN 202211030391
(71) Applicant: BYD Company Limited, Shenzhen, Guangdong 518118 (CN)
(72) Inventor: ZHAO, Lihong, Shenzhen, Guangdong 518118 (CN); ZHANG, Aodong, Shenzhen, Guangdong 518118 (CN); LUO, Wenhai, Shenzhen, Guangdong 518118 (CN); CHEN, Yuwen, Shenzhen, Guangdong 518118 (CN)
(74) Representative: Taor, Simon Edward William
(86) International application number: PCT/CN2023/091122
(87) International publication number: WO 2024/041020

(57) **Abstract**

The invention provides an optical structure, a terminal shell and a terminal. The optical structure comprises a substrate layer, a pattern layer and a micro lens layer, wherein the substrate layer comprises a first surface and a second surface which are opposite to each other; the pattern layer is arranged on the first face of the base material layer and comprises a plurality of pattern units arranged in an array mode, and each pattern unit is a part of a preset pattern. The micro-lens layer is arranged on the second face of the base material layer and comprises a plurality of micro-lenses arranged in an array mode, each micro-lens corresponds to one pattern unit, each pattern unit is located in the projection of the corresponding micro-lens on the pattern layer, and the micro-lenses are used for enabling the pattern units to form a preset pattern with the three-dimensional effect. According to the optical structure, the terminal shell and the terminal provided by the invention, each pattern unit in the pattern layer is set as one part of the preset pattern, so that the preset pattern with a three-dimensional effect can be formed through the plurality of micro lenses.

## Description

### CROSS-REFERENCE TO RELATED APPLICATIONS

The present application claims priority to Chinese Patent Application No. 202211030391.2 filed on August 25, 2022, titled "OPTICAL STRUCTURE, TERMINAL SHELL AND TERMINAL", which is incorporated herein by reference in its entirety.

### FIELD

The present application relates to the field of optical structures, specifically to an optical structure, a terminal shell, and a terminal.

### BACKGROUND

With the improvement of the overall consumption level, users have higher and higher requirements for the aesthetics of terminal shells. A microlens array and a pattern are usually arranged on a housing of electronic devices, such as mobile phones and tablet computers. The magnifying effect of the microlens array creates an enlarged pattern to improve the aesthetics of the electronic device's appearance.

At present, patterns presented by terminal shells are all planar optical effects, lacking three-dimensional sense.

### SUMMARY

A first aspect of the present application provides an optical structure. The optical structure 100 includes a base material layer 10, a pattern layer 20, and a microlens layer 30, and the base material layer 10 includes a first surface 11 and a second surface 12 opposite to each other. The pattern layer 20 is arranged on the first surface 11 of the base material layer 10, and the pattern layer 20 includes a plurality of pattern units 21 arranged in an array, and each of the pattern units 21 is a portion of a preset pattern. The microlens layer 30 is arranged on the second surface 12 of the base material layer 10, and the microlens layer 30 includes a plurality of microlenses 31 arranged in an array. Each of the microlenses 31 corresponds to one pattern unit 21, each of the pattern units 21 is located within the projection of the corresponding microlens 31 on the pattern layer 20, and the plurality of microlenses 31 are used to cause the plurality of pattern units 21 to form the preset pattern with a three-dimensional (3D) effect.

In an example of the present application, the preset pattern is a projection of a figure arranged on a three-dimensional structure on a plane, and projections of figures on the three-dimensional structure on the plane do not have an overlapping area.

In an example of the present application, a plurality of pattern units 21 in each row of pattern units satisfy a first preset condition. The first preset condition includes a first combined pattern overlapping with a first sub-pattern of the corresponding preset pattern, the first combined pattern is formed by translating and combining the plurality of pattern units 21 in each row of pattern units in a first preset direction, the first sub-pattern is a partial pattern of the preset pattern extending a first preset distance in a second preset direction, and the second preset direction is perpendicular to the first preset direction. A plurality of pattern units 21 in each column of pattern units satisfy a second preset condition. The second preset condition includes a second combined pattern overlapping with a second sub-pattern of the corresponding preset pattern, the second combined pattern is formed by translating and combining the plurality of pattern units 21 in each column of pattern units in a second preset direction, and the second sub-pattern is a partial pattern of the preset pattern extending a second preset distance in the first preset direction.

In an example of the present application, absolute values of the difference in the dimensions of every two adjacent pattern units 21 in each row of pattern units in a first preset direction are equal. Absolute values of the difference in the dimensions of every two adjacent pattern units 21 in each column of pattern units in a second preset direction are equal.

In an example of the present application, two adjacent pattern units 21 in each row of pattern units are partially identical. The first preset condition includes a first combined pattern overlapping with a corresponding first sub-pattern, and the first combined pattern is formed by combining the plurality of pattern units 21 in such a way that the identical portions overlap. Two adjacent pattern units 21 in each column of pattern units are partially identical. The second preset condition includes a second combined pattern overlapping with a corresponding second sub-pattern, and the second combined pattern is formed by combining the plurality of pattern units 21 in such a way that the identical portions overlap.

In an example of the present application, the plurality of pattern units 21 in each row of pattern units are respectively portions cut from the corresponding first sub-pattern in a first preset direction. The plurality of pattern units 21 in each column of pattern units are respectively portions cut from the corresponding second sub-pattern in a second preset direction.

In an example of the present application, the first and last pattern units 21 in each row of pattern units respectively include potions at both ends of the corresponding first sub-pattern in the first preset direction. The cut portions included in each row of pattern units, gradually increase from the first and last pattern units 21 to the middle pattern unit 21, and the cut portion included in the middle pattern unit 21, includes at least the middle portion of the corresponding first sub-pattern. The first and last pattern units 21 in each column of pattern units respectively include potions at both ends of the corresponding second sub-pattern in the second preset direction. The cut portions included in each column of pattern units, gradually increases from the first and last pattern units 21 to the middle pattern unit 21, and the cut portion included in the middle pattern unit 21, includes at least the middle portion of the corresponding second sub-pattern.

In an example of the present application, the pattern layer 20 includes a plurality of pattern regions 22 arranged in an array. Each of the pattern regions 22 corresponds to one microlens 31, and the center of each of the pattern regions 22 is aligned with the center of the corresponding microlens 31. Each of the pattern units 21 is arranged at a preset position in the corresponding pattern region 22, so that each of the pattern units 21 corresponds to a preset portion of the corresponding microlens 31, and a corresponding pattern is formed through the corresponding microlens 31.

In an example of the present application, the shape of the pattern region 22 is the same as the shape of the projection of each of the microlenses 31 on the pattern layer 20.

In an example of the present application, the shape of the pattern region 22 is different from the shape of the projection of each of the microlenses 31 on the pattern layer 20.

In an example of the present application, the base material layer 10 includes at least one of a transparent polymer layer and a glass layer.

In an example of the present application, the base material layer 10 is a glass layer. The plurality of microlenses 31 are outwardly extending portions of glass of the glass layer, and/or a plurality of grooves 13 arranged in an array are arranged on the surface of the glass layer far away from the microlenses 31. Each of the grooves 13 corresponds to one pattern unit and is covered by a corresponding pattern unit 21, and the shape of each of the grooves 13 is the same as the corresponding pattern unit 21.

In an example of the present application, an outer contour of the microlens 31 is arc-shaped, the projection of the microlens 31 on the base material layer 10 is circular, and a diameter of the projection is a value in the range of 100-300 µm. A height of the microlens 31 is a value in the range of 0.1-20 µm, and the height of the microlens 31 is a distance between an end of the microlens 31 far away from the base material layer 10 and the base material layer 10.

In an example of the present application, a thickness of the base material layer 10 is a value in the range of 0.1-0.6 mm, and the thickness of the base material layer 10 is the distance between the first surface 11 and the second surface 12.

In an example of the present application, the pattern unit 21 can be formed of a metallic material, or a color-developing material.

A second aspect of the present application provides a terminal shell 200. The terminal shell 200 includes an optical structure 100 according to the first aspect.

In an example of the present application, the terminal shell 200 includes a transparent back cover 50. The optical structure 100 is arranged on a side of the transparent back cover 50 close to the interior of the terminal. The pattern layer 20 of the optical structure 100 is bonded to the transparent back cover 50, and an optical adhesive can be arranged between the pattern layer 20 and the transparent back cover 50 to adhere the optical structure 100 to the inner surface of the transparent back cover 50.

In an example of the present application, the preset pattern is formed by: incident light enters from the transparent back cover 50 and reaches the microlens layer 30 through the pattern layer 20, and is reflected at the plurality of microlenses 31 to generate reflected light. The reflected light propagates to the pattern layer 20, and forms an image on the side of the pattern layer 20 far away from the base material layer 10, thereby forming the preset pattern with a three-dimensional suspension effect.

In an example of the present application, the transparent back cover 50 can be made of a transparent polymer or glass.

A third aspect of the present application provides a terminal. The terminal includes a terminal shell 200 according to the second aspect.

### BRIEF DESCRIPTION OF THE DRAWINGS

In order to illustrate more clearly the technical solution of the present application, the accompanying drawings required to be used in the examples will be briefly introduced below, and it is obvious that the accompanying drawings described below are some examples of the present application, and for a person skilled in the art, other accompanying drawings can also be obtained according to these accompanying drawings without paying creative labor.
FIG. 1 is a side view of an optical structure provided by an example of the present application.
FIG. 2 is a schematic plan view of a pattern layer in FIG. 1.
FIG. 3 is a schematic plan view of a microlens layer in FIG. 1.
FIG. 4 is a schematic plan perspective view showing the pattern layer and the microlens layer in FIG. 1.
FIG. 5 is a schematic view of a preset pattern with a three-dimensional effect formed by the optical structure in FIG. 1.
FIG. 6 is a schematic view of a preset pattern provided by an example of the present application.
FIG. 7 is a schematic view of a preset pattern provided by another example of the present application.
FIG. 8 is a schematic view of a first sub-pattern provided by an example of the present application.
FIG. 9 is a schematic view of a second sub-pattern provided by an example of the present application.
FIG. 10 is a schematic plan view of a pattern layer provided by another example of the present application.
FIG. 11 is a schematic view of a first sub-pattern provided by another example of the present application.
FIG. 12 is a schematic view of a second sub-pattern provided by another example of the present application.
FIG. 13 is a side view of an optical structure provided by another example of the present application.
FIG. 14 is a schematic view of a straight line SL₁ and a line segment LS₁ provided by an example of the present application.
FIG. 15 is a schematic view of movement of a first pattern frame.
FIG. 16 is a schematic configuration diagram of a plurality of first divided patterns.
FIG. 17 is a schematic view of a straight line SL₂ and a line segment LS₂ provided by an example of the present application.
FIG. 18 is a schematic configuration diagram of a plurality of second divided patterns.
FIG. 19 is a side view of a terminal shell provided by an example of the present application.

### Explanation of main component symbols:

optical structure 100
base material layer 10
pattern layer 20
microlens layer 30
pattern unit 21
pattern region 22
microlens 31
first surface 11
second surface 12
groove 13
terminal shell 200
transparent back cover 50

### DETAILED DESCRIPTION

Hereinafter, the technical solutions in the examples of the present application will be clearly and completely described with reference to the accompanying drawings in the examples of the present application, and it is obvious that the described examples are only a part of the examples of the present application, but not all the examples. According to the examples in the present application, all other examples obtained by a person skilled in the art without paying creative labor belong to the scope of protection of the present application.

In the description of the present application, the terms "first", "second", etc. are used to distinguish different objects, and are not used to describe a specific order. In addition, the orientation or positional relationship indicated by the terms "upper", "lower", "inner", "outer", etc. is based on the orientation or positional relationship shown in the drawings, and is only used to facilitate and simplify the description of the present application, and does not indicate or imply that the referred device or element must have a specific orientation, be constructed and operated in a specific orientation, and therefore cannot be understood as a limitation of the present application.

In the description of the present application, unless otherwise explicitly specified and defined, the term "connected" should be understood broadly, for example, it can be fixed, detachable, or integrally connected; it can be directly connected, indirectly connected through an intermediate medium, or it can be the internal communication of two elements; it can be a communication connection; it can be an electrical connection. A person skilled in the art can understand the specific meanings of the above-mentioned terms in the present application according to the specific circumstances.

It should be illustrated that the drawings provided in the examples of the present application only illustrate the basic concept of the present application in a schematic manner, and only components related to the present application are shown in the drawings instead of drawing according to the number, shape, and dimension of the components in actual implementation, and the type, number, and proportion of each component in actual implementation can be arbitrarily changed, and the layout of the components can be more complicated.

In order to solve the above-described technical problems, the present application provides an optical structure, a terminal shell, and a terminal, thus forming a preset pattern with a three-dimensional effect.

In an optical structure, a terminal shell, and a terminal provided by the present application, by setting each of the pattern units in the pattern layer as a portion of a preset pattern which is originally a planar pattern, and by optical action of the microlens layer, the preset pattern formed by the plurality of microlenses can exhibit a three-dimensional effect.

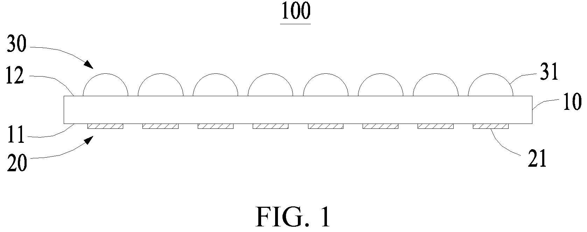

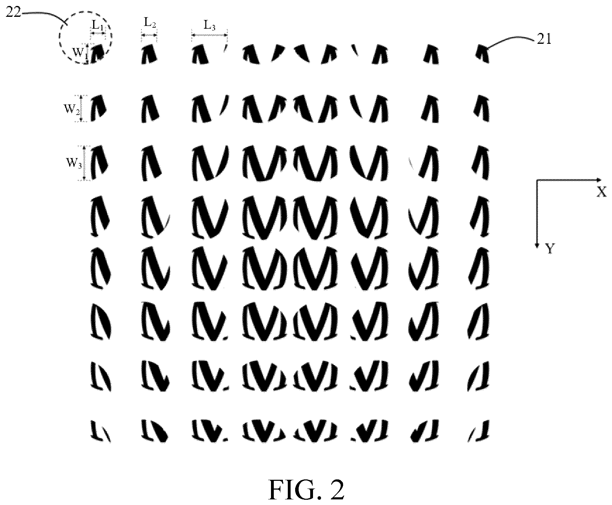

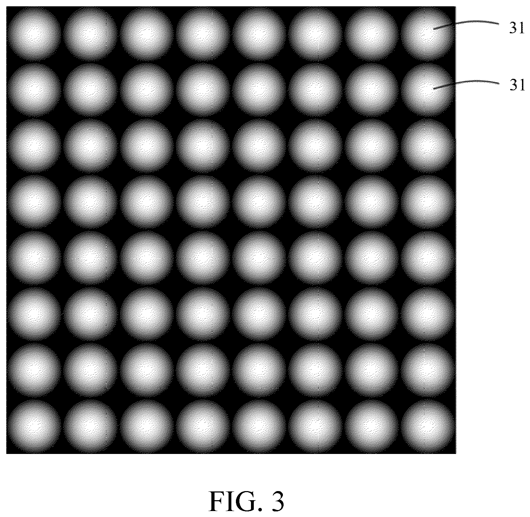

Referring to FIGS. 1 to 3, FIG. 1 is a side view of an optical structure 100 provided by an example of the present application, FIG. 2 is a schematic plan view of the pattern layer 20 in FIG. 1, and FIG. 3 is a schematic plan view of the microlens layer 30 in FIG. 1. As shown in FIG. 1, the optical structure 100 includes a base material layer 10, a pattern layer 20, and a microlens layer 30, and the base material layer 10 includes a first surface 11 and a second surface 12 opposite to each other. The pattern layer 20 is arranged on the first surface 11 of the base material layer 10, and the pattern layer 20 includes a plurality of pattern units 21 arranged in an array, and as shown in FIG. 2, each of the pattern units 21 is a portion of a preset pattern. As shown in FIGS. 1 and 3, the microlens layer 30 is arranged on the second surface 12 of the base material layer 10, and the microlens layer 30 includes a plurality of microlenses 31 arranged in an array. Each of the microlenses 31 corresponds to one pattern unit 21, each of the pattern units 21 is located within the projection of the corresponding microlens 31 on the pattern layer 20, and the plurality of microlenses 31 are used to cause the plurality of pattern units 21 to form the preset pattern with a three-dimensional (3D) effect.

In the optical structure 100 provided by an example of the present application, by setting each of the pattern units 21 in the pattern layer 20 as a portion of a preset pattern which is originally a planar pattern, and by optical action of the microlens layer 30, the preset pattern formed by the plurality of microlenses 31 can exhibit a three-dimensional effect.

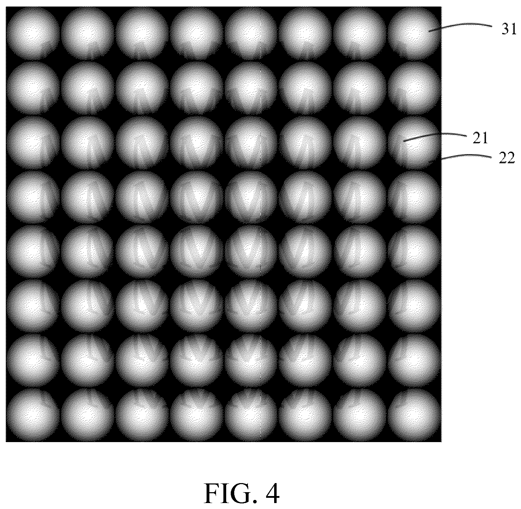

Referring to FIG. 4, FIG. 4 is a schematic plan perspective view showing both the pattern layer 20 and the microlens layer 30 in FIG. 1. As shown in FIG. 4, each of the microlenses 31 corresponds to one pattern unit 21, and each of the pattern units 21 is located within the projection of the corresponding microlens 31 on the pattern layer 20.

In some examples, as shown in FIGS. 2 and 4, the pattern layer 20 includes a plurality of pattern regions 22 arranged in an array. Each of the pattern regions 22 corresponds to one microlens 31, and the center of each of the pattern regions 22 is aligned with the center of the corresponding microlens 31. Each of the pattern units 21 is arranged at a preset position in the corresponding pattern region 22, so that each of the pattern units corresponds to a preset portion of the corresponding microlens, and a corresponding pattern is formed through the corresponding microlens.

The preset position of each of the pattern regions 22 overlaps with the projection of the preset portion of the corresponding microlens 31 on the pattern layer 20. By aligning the pattern region 22 with the corresponding microlens 31, the pattern unit 21 at the preset position of the pattern region 22 overlaps with the projection of the preset portion of the corresponding microlens 31 on the pattern layer 20, so that the pattern unit 21 can form a corresponding pattern through the corresponding microlens 31, and the plurality of pattern units 21 can form the preset pattern with a three-dimensional effect through the plurality of microlenses 31.

According to the imaging requirements of the pattern units 21, each image unit 21 needs to overlaps with the projection of the preset portion of the microlens 31 on the pattern layer 20. By predetermining each of the pattern units 21 arranged at a preset position in a pattern region 22, the preset position satisfies the requirement that when the microlens 31 is aligned with the corresponding image area 22, the projection of the preset portion of the microlens 31 on the pattern layer 20 overlaps with the pattern unit 21 just right. The preset position at which each of the pattern units 21 is arranged in a pattern region 22, can be determined by a pre-imaging experiment.

In some examples, the shape of the pattern region 22 is the same as the shape of the projection of each of the microlenses 31 on the pattern layer 20, for example, the shape of the projection of each of the microlenses 31 on the pattern layer 20 is a circle, and the shape of the pattern region 22 is also a circle. The dimension of the pattern region 22 can be less than or equal to the dimension of the projection of each of the microlenses 31 on the pattern layer 20, for example, the diameter of the projection of each of the microlenses 31 on the pattern layer 20 is greater than or approximately equal to the diameter of the pattern region 22. By setting each of the pattern regions 22 to overlap with the projection of the corresponding microlens 31 on the pattern layer 20, each of the pattern regions 22 can be aligned with the corresponding microlens 31, so that the pattern unit 21 located at the preset position of the pattern region 22 overlaps with the corresponding position of projection of the corresponding microlens 31 on the pattern layer 20, and the pattern units 21 can form a corresponding pattern through the corresponding microlens 31.

In some examples, the shape of the pattern region 22 is different from the shape of the projection of each of the microlenses 31 on the pattern layer 20, for example, the shape of the projection of each of the microlenses 31 on the pattern layer 20 is circular, and the shape of the pattern region 22 is a square circumscribed to the circle.

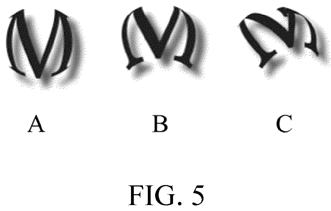

Referring to FIG. 5, FIG. 5 is a schematic view of a preset pattern with a three-dimensional effect formed by the optical structure 100 in FIG. 1. A, B, and C are preset patterns viewed from different viewing angles, respectively.

A plurality of pattern regions 22 of the pattern layer 20 can be arranged at intervals. Alternatively, two adjacent pattern regions 22 can be connected. The plurality of microlenses 31 arranged in an array can be arranged at intervals. Alternatively, two adjacent microlenses 31 can be in contact with each other. For example, each of the microlenses 31 is hemispherical and the projections of every two adjacent microlenses 31 on the pattern layer 20 are tangent.

The projection of each of the microlenses 31 on the pattern layer 20 is an orthographic projection of the microlens 31 on the pattern layer 20.

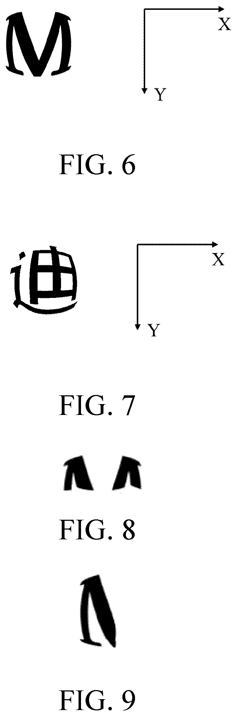

In some examples, the preset pattern is a projection of a figure arranged on a three-dimensional structure on a plane, and projections of figures on the three-dimensional structure on the plane do not have an overlapping area. For example, a figure arranged on the three-dimensional structure can be a letter or a Chinese character arranged on a sphere, and for example, as shown in FIGS. 6 and 7, the figure arranged on the three-dimensional structure can be a letter "M" or a Chinese character "Di" arranged on a sphere.

In the present application, the projections of figures arranged on a three-dimensional structure on a plane are used as the preset pattern, the preset pattern is divided into a plurality of portions, and the plurality of portions serve as the plurality of pattern units 21. Each of the pattern units 21 is imaged by a corresponding microlens 31. The plurality of pattern units 21 form images by respective corresponding microlenses 31, and the images will be stitched to present a complete preset pattern with a three-dimensional suspension effect. For example, the preset pattern is a letter "M" arranged on a sphere, the letter "M" is divided into a plurality of portions, and the plurality of portions serve as the plurality of pattern units 21 (as shown in FIG. 2). Each of the pattern units 21 is imaged by a corresponding microlens 31. The plurality of pattern units 21 form images by respective corresponding microlenses 31, and the images will be stitched to present a complete letter "M" with a three-dimensional suspension effect (as shown in FIG. 5).

The figures arranged on the three-dimensional structure can be an arbitrary figure or a combination of a plurality of arbitrary figures, and for example, figures arranged on the three-dimensional structure can be a plurality of letters or Chinese characters, such as a Chinese character "Beijing", a letter combination "M N", or the like.

The three-dimensional structure can be any three-dimensional structure, such as irregularly undulating three-dimensional figures such as ellipsoids, hills, pyramids, etc. The final three-dimensional suspension effect varies with the selected three-dimensional structure.

Referring to FIG. 2 again, in some examples, as shown in FIG. 2, a plurality of pattern units 21 in each row of pattern units satisfy a first preset condition. The first preset condition includes a first combined pattern overlapping with a first sub-pattern of the corresponding preset pattern, the first combined pattern is formed by translating and combining the plurality of pattern units 21 in a first preset direction (X direction as shown in FIG. 2), the first sub-pattern is a partial pattern of the preset pattern extending a first preset distance in a second preset direction (Y direction as shown in FIG. 6), and the second preset direction is perpendicular to the first preset direction. A plurality of pattern units 21 in each column of pattern units satisfy a second preset condition. The second preset condition includes a second combined pattern overlapping with a second sub-pattern of the corresponding preset pattern, the second combined pattern is formed by translating and combining the plurality of pattern units 21 in a second preset direction (Y direction as shown in FIG. 2), and the second sub-pattern is a partial pattern of the preset pattern extending a second preset distance in the first preset direction (X direction as shown in FIG. 6).

The preset pattern can be obtained by combining a plurality of first combined patterns, and the plurality of first combined patterns are formed by translating and combining a plurality of pattern units 21 in all row pattern units 21. The preset pattern can be obtained by combining a plurality of second combined patterns, and the second combined patterns are formed by translating and combining a plurality of pattern units 21 in all column pattern units 21.

In some examples, as shown in FIG. 2, two adjacent pattern units 21 in each row of pattern units are partially identical. The first preset condition includes a first combined pattern overlapping with a corresponding first sub-pattern, and the first combined pattern is formed by combining the plurality of pattern units 21 in such a way that the identical portions overlap. Two adjacent pattern units 21 in each column of pattern units are partially identical. The second preset condition includes a second combined pattern overlapping with a corresponding second sub-pattern, and the second combined pattern is formed by combining the plurality of pattern units 21 in such a way that the identical portions overlap.

For example, as shown in FIG. 2, a plurality of pattern units 21 of the pattern layer 20 can be divided into a plurality of rows of pattern units 21. The plurality of rows of pattern units 21 include a first row of pattern units 21, a second row of pattern units 21... and an i-th row of pattern units 21 arranged sequentially in the Y direction. A first combined pattern overlaps with a first sub-pattern of the preset pattern shown in FIG. 8, and the first combined pattern is formed by translating and combining the plurality of pattern units 21 in the first row of pattern units 21 in the X direction. A plurality of pattern units 21 of the pattern layer 20 can be further divided into a plurality of columns of pattern units 21. The plurality of columns of pattern units 21 include a first column of pattern units 21, a second column of pattern units 21,..., and a j-th column of pattern units 21 arranged sequentially in the X direction, and j and i can be equal or unequal. A second combined pattern overlaps with a second sub-pattern of the preset pattern shown in FIG. 9, and the second combined pattern is formed by translating and combining the plurality of pattern units 21 in the first column of pattern units 21 in the Y direction.

In the present application, the preset pattern can be obtained by combining a plurality of first combined patterns in such a way that the identical portions overlap, and the plurality of first combined patterns are formed by translating and combining a plurality of pattern units 21 in all row pattern units 21. The preset pattern can be obtained by combining a plurality of second combined patterns in such a way that the identical portions overlap, and the second combined patterns are formed by translating and combining a plurality of pattern units 21 in all column pattern units 21.

In other examples, endpoints of the two adjacent pattern units 21 in each row of pattern units can overlap, and the endpoints are far away from the center of the pattern units 21 in the first preset direction, that is, the two adjacent pattern units 21 in each row of pattern units can be connected with each other just right. A plurality of pattern units 21 in each row of pattern units satisfy the condition, and the condition includes a first combined pattern overlapping with a corresponding first sub-pattern, and the first combined pattern is formed by combining every two adjacent pattern units 21 in such a way that the two pattern units are connected front to back. Endpoints of the two adjacent pattern units 21 in each column of pattern units can overlap, and the endpoints are far away from the center of the pattern units 21 in the second preset direction, that is, the two adjacent pattern units 21 in each column of pattern units can be connected with each other just. A plurality of pattern units 21 in each column of pattern units satisfy the condition, and the condition includes a second combined pattern overlapping with a corresponding second sub-pattern, and the second combined pattern is formed by combining every two adjacent pattern units 21 in such a way that the two pattern units are connected front to back.

In the present application, a first combined pattern formed by combining a plurality of pattern units 21 in each row of pattern units, overlaps with a first sub-pattern of the corresponding preset pattern, and a second combined pattern formed by combining a plurality of pattern units 21 in each column of pattern units, overlaps with a second sub-pattern of the corresponding preset pattern, so that the plurality of pattern units 21 of the pattern layer 20 can be imaged by the plurality of microlenses 31 to obtain a complete preset pattern.

In some examples, absolute values of the difference in the dimensions of every two adjacent pattern units 21 in each row of pattern units in a first preset direction are equal. The dimensions of the pattern units 21 in the first preset direction are lengths of the pattern units 21, such as L₁, L₂, and L₃ shown in FIG. 2. Absolute values of the difference in the dimensions of every two adjacent pattern units 21 in the first preset direction are equal, that is, the absolute values of the difference in lengths of every two adjacent pattern units 21 are equal, and as shown in FIG. 2, the absolute value of the difference between L₁ and L₂ is equal to the absolute value of the difference between L₂ and L₃.

The difference in the dimensions of every two adjacent pattern units 21 in a first preset direction is equal to the difference in the first preset distance, a first sub-pattern extends the first preset distance in a second preset direction, the first sub-pattern corresponds to a first combined pattern, and the first combined pattern is formed by translating and combining the plurality of pattern units 21 in every two adjacent pattern units 21.

In some examples, absolute values of the difference in the dimensions of every two adjacent pattern units 21 in each column of pattern units in a second preset direction are equal. The dimensions of the pattern units 21 in the second preset direction are widths of the pattern units 21, such as W₁, W₂, and W₃ shown in FIG. 2. Absolute values of the difference in dimensions of every two adjacent pattern units 21 in the second preset direction are equal, that is, the absolute values of the difference in widths of every two adjacent pattern units 21 are equal, and as shown in FIG. 2, the absolute value of the difference between W₁ and W₂ is equal to the absolute value of the difference between W₂ and W₃.

The difference in the dimensions of every two adjacent pattern units 21 in a second preset direction is equal to the difference in the second preset distance, a second sub-pattern extends the second preset distance in a first preset direction, the second sub-pattern corresponds to a second combined pattern, and the second combined pattern is formed by translating and combining the plurality of pattern units 21 inevery two adjacent pattern units 21.

By setting the difference in lengths of every two adjacent pattern units 21 in each row of pattern units to be equal, and the difference in widths of every two adjacent pattern units 21 in each column of pattern units to be equal, it is possible to avoid distortion of the image formed by the plurality of microlenses 31, which affects the presentation effect of the preset pattern.

In some examples, as shown in FIG. 2, the plurality of pattern units 21 in each row of pattern units are respectively portions cut from the corresponding first sub-pattern in a first preset direction. The plurality of pattern units 21 in each column of pattern units are respectively portions cut from the corresponding second sub-pattern in a second preset direction.

For example, as shown in FIGS. 2, 8, and 9, a plurality of pattern units 21 in the first row of pattern units 21 in FIG. 2 are respectively portions cut from the first sub-pattern shown in FIG. 8 in the X direction. A plurality of pattern units 21 in the first column of pattern units 21 in FIG. 2 are respectively portions cut from the second sub-pattern shown in FIG. 9 in the Y direction.

A plurality of pattern units 21 arranged in the first preset direction in each row of pattern units are respectively portions cut from the corresponding first sub-patterns in the first preset direction. A plurality of pattern units 21 arranged in the second preset direction in each column of pattern units are respectively portions cut from the corresponding second sub-patterns in the second preset direction.

By setting a plurality of pattern units 21 arranged in the first preset direction in each row of pattern units as portions cut from the corresponding first sub-patterns in the same direction, and setting a plurality of pattern units 21 arranged in the second preset direction in each column of pattern units as portions cut from the corresponding second sub-patterns in the same direction, pattern misalignment in the plurality of pattern units 21 in each row of pattern units and pattern misalignment in the plurality of pattern units 21 in each column of pattern units can be avoided, thereby avoiding misalignment in the image formed by the plurality of microlenses 31, so that the presentation effect of the preset pattern is better.

In some examples, the first and last pattern units 21 in each row of pattern units respectively include potions at both ends of the corresponding first sub-pattern in the first preset direction. The cut portions included in each row of pattern units, gradually increase from the first and last pattern units 21 to the middle pattern unit 21, and the cut portion included in the middle pattern unit 21, includes at least the middle portion of the corresponding first sub-pattern. The first and last pattern units 21 in each column of pattern units respectively include potions at both ends of the corresponding second sub-pattern in the second preset direction. The cut portions included in each column of pattern units, gradually increases from the first and last pattern units 21 to the middle pattern unit 21, and the cut portion included in the middle pattern unit 21, includes at least the middle portion of the corresponding second sub-pattern.

For example, as shown in FIGS. 2, 8 and 9, the first and last pattern units 21 in the first row of pattern units 21 in FIG. 2 respectively include potions at both ends of the first sub-pattern shown in FIG. 8 in the first preset direction. The cut portions included in the first row of pattern units 21, gradually increase from the first and last pattern units 21 to the middle pattern unit 21, and the cut portion included in the middle pattern unit 21, includes at least the middle portion of the corresponding first sub-pattern shown in FIG 8. The first and last pattern units 21, of the plurality of pattern units 21 in the first column of pattern units 21 in FIG. 2, respectively include potions at both ends of the second sub-pattern shown in FIG. 9 in the second preset direction. The cut portions included in the first column of pattern units 21, gradually increase from the first and last pattern units 21 to the middle pattern unit 21, and the cut portion included in the middle pattern unit 21, includes at least the middle portion of the second sub-pattern shown in FIG 9.

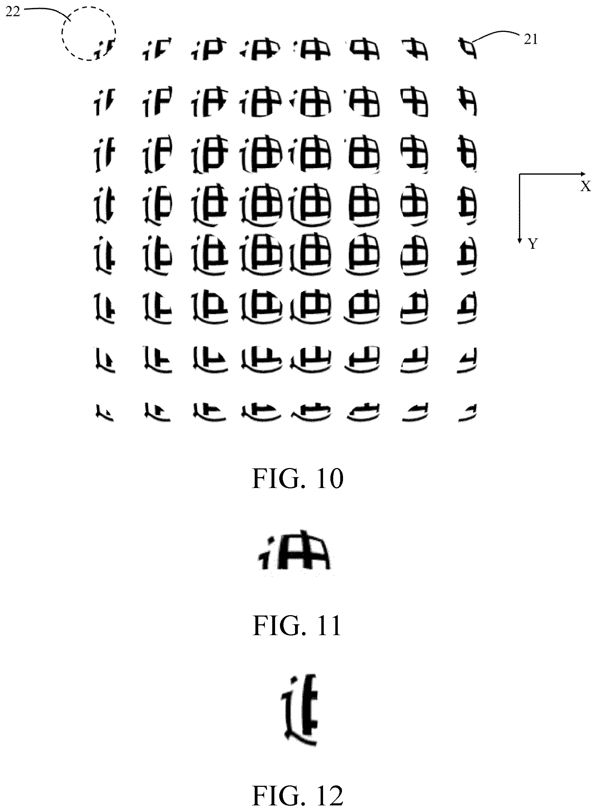

Referring to FIG. 10, FIG. 10 is a schematic plan view of a pattern layer 20 provided by another example of the present application. As shown in FIG. 10, a plurality of pattern units 21 of the pattern layer 20 can be divided into a plurality of rows of pattern units 21. The plurality of rows of pattern units 21 include a first row of pattern units 21, a second row of pattern units 21... and a p-th row of pattern units 21 arranged sequentially in the Y direction. A first combined pattern overlaps with a first sub-pattern of the preset pattern shown in FIG. 11, and the first combined pattern is formed by translating and combining the plurality of pattern units 21 in the first row of pattern units 21 in the X direction. A plurality of pattern units 21 of the pattern layer 20 can be further divided into a plurality of columns of pattern units 21. The plurality of columns of pattern units 21 include a first column of pattern units 21, a second column of pattern units 21,..., and a q-th column of pattern units 21 arranged sequentially in the X direction, and p and q can be equal or unequal. A second combined pattern overlaps with a second sub-pattern of the preset pattern shown in FIG. 12, and the second combined pattern is formed by translating and combining the plurality of pattern units 21 in the first column of pattern units 21 in the Y direction.

As shown in FIGS. 10, 11, and 12, a plurality of pattern units 21 in the first row of pattern units 21 are respectively portions cut from the first sub-pattern shown in FIG. 11 in the X direction. A plurality of pattern units 21 in the first column of pattern units 21 are respectively portions cut from the second sub-pattern shown in FIG. 12 in the Y direction.

As shown in FIGS. 10, 11, and 12, the first and last pattern units 21 in the first row of pattern units 21 respectively include potions at both ends of the first sub-pattern shown in FIG.11 in the first preset direction. The cut portions included in the first row of pattern units, gradually increase from the first and last pattern units 21 to the middle pattern unit 21, and the cut portion included in the middle pattern unit 21, includes at least the middle portion of the first sub-pattern shown in FIG.11. The first and last pattern units 21, of the plurality of pattern units 21 in the first column of pattern units 21, respectively include potions at both ends of the second sub-pattern shown in FIG. 12 in the second preset direction. The cut portions included in the first column of pattern units 21, gradually increase from the first and last pattern units 21 to the middle pattern unit 21, and the cut portion included in the middle pattern unit 21, includes at least the middle portion of the second sub-pattern shown in FIG 12.

In some examples, the base material layer 10 includes at least one of a transparent polymer layer and a glass layer.

The material of the transparent polymer layer can be selected from PC (polycarbonate), PET (polyethylene ethyl terephthalate), PI (polyimide), and the like.

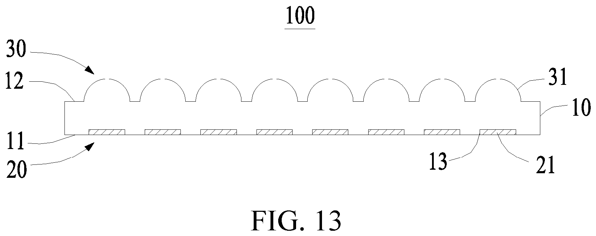

Referring to FIG. 13, FIG. 13 is a side view of an optical structure 100 provided by another example of the present application. In some examples, the base material layer 10 is a glass layer. As shown in FIG. 13, the plurality of microlenses 31 are outwardly extending portions of glass of the glass layer, and/or a plurality of grooves 13 arranged in an array are arranged on the surface of the glass layer far away from the microlenses 31. Each of the grooves 13 corresponds to one pattern unit and is covered by a corresponding pattern unit 21, and the shape of each of the grooves 13 is the same as the corresponding pattern unit 21.

By setting the plurality of microlenses 31 as outwardly extending portions of the base material layer 10, the microlens layer 30 can be directly manufactured on the base material layer 10, so that the manufacturing process is simplified.

By setting a plurality of grooves 13 on the side of the base material layer 10 far away from the microlens layer 30, and setting a plurality of pattern units 21 in the plurality of grooves 13, a thickness of the optical structure 100 can be reduced, so that it is conducive to lightweightness and miniaturization of the product.

In some examples, an outer contour of the microlens 31 is arc-shaped, the projection of the microlens 31 on the base material layer 10 is circular, and a diameter of the projection is a value in the range of 100-300 µm.

The orthographic projection of the microlens 31 on the base material layer 10 is circular.

In other examples, the microlens 31 also can be other shapes, such as cylindrical shapes and the like.

In some examples, a height of the microlens 31 is a value in the range of 0.1-20 µm, and the height of the microlens 31 is a distance between an end of the microlens 31 far away from the base material layer 10 and the base material layer 10. When the microlens 31 is an outwardly extending portion of glass of the glass layer, the height of the microlens 31 is a dimension of the microlens 31 extending outwardly.

In some examples, a thickness of the base material layer 10 is a value in the range of 0.1-0.6 mm, and the thickness of the base material layer 10 is the distance between the first surface 11 and the second surface 12.

In some examples, the pattern unit 21 can be formed of a metallic material, such as chromium, or a color-developing material, such as ink. The material of the microlens 31 can be a transparent polymer or glass.

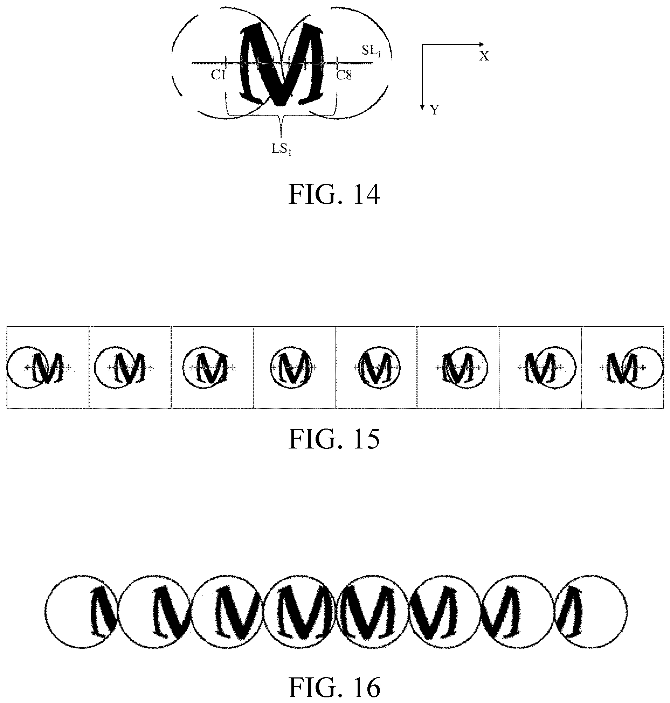

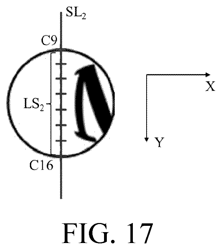

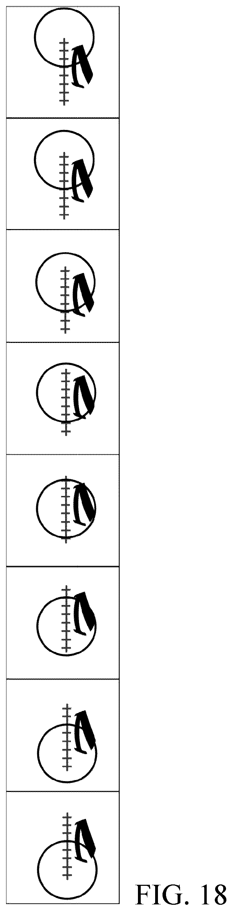

In some examples, a method for designing a plurality of pattern units 21 of the pattern layer 20 can include the following steps: a straight line SL₁ is determined, an extending direction of the straight line SL₁ is parallel to the first preset direction, and the straight line SL₁ passes through the center of the preset pattern, as shown in FIG. 14. Two points located on both sides of the preset pattern on the straight line SL₁ are selected to serve as two endpoints of a line segment LS₁, and the two endpoints are connected to obtain the line segment LS₁, as shown in FIG. 14. The line segment LS₁ is evenly divided into a plurality of sub-line segments to obtain the endpoints of the plurality of sub-line segments, for example, C1 to C8 as shown in FIG. 14. A first pattern frame is moved in the first preset direction from an endpoint farthest from the preset pattern (C1 as shown in FIG. 14) and moved a plurality of times, the center of the first pattern frame after each movement overlaps with one endpoint (as shown in FIG. 15), a portion of the preset pattern falling into the first pattern frame after each movement is obtained, then the portion serves as a first divided pattern (as shown in FIG. 16), and the first divided pattern and the first pattern frame are combined to obtain a first divided pattern region. A straight line SL₂ is determined, an extending direction of the straight line SL₂ is parallel to the second preset direction, and the straight line SL₂ passes through the center of each of the first divided pattern regions, as shown in FIG. 17. Two points located on both sides of the first divided pattern on the straight line SL₂ are selected to serve as two endpoints of a line segment LS₂, and the two endpoints are connected to obtain the line segment LS₂, as shown in FIG. 17. The line segment LS₂ is evenly divided into a plurality of sub-line segments to obtain the endpoints of the plurality of sub-line segments, for example, C9 to C16 as shown in FIG. 17. A second pattern frame is moved in the second preset direction from an endpoint farthest from the first divided pattern (C9 as shown in FIG. 17) and moved a plurality of times, the center of the second pattern frame after each movement overlaps with one endpoint, a portion of the first divided pattern falling into the second pattern frame after each movement is obtained, then the portion serves as a second divided pattern (as shown in FIG. 18), a plurality of second pattern frames constitute a plurality of pattern regions 22, and a plurality of second divided patterns constitute a plurality of pattern units 21.

In some examples, a shape and dimension of the first pattern frame are the same as the projection of the microlens 30. For example, the projection of the microlens 30 on the pattern layer 20 is circular, and the first pattern frame is circular and with a diameter equal to the projection of the microlens 30 on the pattern layer 20.In other examples, the projection of the microlens 30 on the pattern layer 20 is circular, and the first pattern frame is a square circumscribed to the circle.

In some examples, a shape and dimension of the second pattern frame are the same as the projection of the microlens 30. For example, the projection of the microlens 30 on the pattern layer 20 is circular, and the second pattern frame is circular and with a diameter equal to the projection of the microlens 30 on the pattern layer 20. In other examples, the projection of the microlens 30 on the pattern layer 20 is circular, and the first pattern frame is a square circumscribed to the circle.

In some examples, a method for manufacturing the optical structure 100 can include the following steps: a microlens mold is prepared. The microlens layer 30 is formed on the first surface 11 of the base material layer 10 by the microlens mold. A coating layer is formed on the second surface 12 of the base material layer 10. A photoresist layer is formed on a side of the coating layer far away from the base material layer 10. A portion of the photoresist layer corresponding to the outside of the plurality of pattern units 21, is removed, to expose a portion of the coating layer corresponding to the outside of the plurality of pattern units 21. The exposed portion of the coating layer is removed, and the portion of the coating layer corresponding to the plurality of pattern units 21 is reserved, to form the plurality of pattern units 21. The remaining portion of the photoresist layer is removed.

The microlens mold with positioning points can be prepared by laser directly writing, mechanical processing and the like.

The microlens layer 30 can be formed on the first surface 11 of the base material layer 10 by means of UV transfer, nanoimprint, hot pressing, etc, by the microlens mold. The microlens layer 30 has a positioning point. For example, the microlens layer 30 can be formed on the first surface 11 of the base material layer 10 by means of UV transfer, by the microlens mold. Specifically, UV adhesive is coated on the first surface 11 of the base material layer 10, the microlens mold is pressed on the UV adhesive, ultraviolet light is irradiated on the side of the microlens mold far away from the UV adhesive to cure the UV adhesive, uncured UV adhesive is then removed, and the UV adhesive is separated from the microlens mold to obtain the microlens layer 30.

The coating layer can be a metal layer, such as a chromium layer.

The photoresist layer can be formed by scraping, spraying, slit spraying, or the like.

The portion of the photoresist layer corresponding to the outside of the plurality of pattern units 21 can be exposed by laser directly writing or film exposure, the exposed portion of the photoresist layer can be removed using a developer to remove the portion of the photoresist layer corresponding to the outside of the plurality of pattern units 21, and the portion of the coating layer corresponding to the outside of the plurality of pattern units 21 can be exposed. Specifically, a portion of the photoresist layer corresponding to the outside of the plurality of pattern units 21 is directly exposed by laser light according to the positioning point of the microlens layer 30, or a mask is arranged on the side of the photoresist layer far away from the base material layer 10 according to the positioning point of the microlens layer 30, a light shielding layer is arranged on the mask, the shape and dimension of the light shielding layer are the same as those of the plurality of pattern units 21, the mask is irradiated with a light source on the side of the mask far away from the photoresist layer, light can pass through areas of the mask other than the light shielding layer, so that a portion of the photoresist layer corresponding to the outside of the plurality of pattern units 21 can be exposed, and the exposed portion of the photoresist layer is then removed using a developer to expose the portion of the coating layer corresponding to the outside of the plurality of pattern units 21.

The exposed portion of the coating layer can be removed using a reagent such as hydrochloric acid or nitric acid, while the portion of the coating layer corresponding to the plurality of pattern units 21 is retained, that is, the pattern layer 20 can be obtained, and then the remaining portion of the photoresist layer can be removed using a dry etching process or a wet etching process.

In some examples, a method for manufacturing the optical structure 100 can include the following steps: the first face 11 of the base material layer 10 is etched to form the microlens layer 30. The second face 12 of the base material layer 10 is etched to form the plurality of grooves 13. And a plurality of pattern units 21 are formed in the plurality of grooves 13.

The microlens layer 30 can be formed by a dry etching process. Specifically, a photoresist layer is formed on the first surface 11 of the base material layer 10, the portion of the photoresist layer corresponding to the outside of the plurality of microlenses 31 is exposed, the exposed portion of the photoresist layer is removed using a developer to expose a portion of the first surface 11 of the base material layer 10 corresponding to the outside of the plurality of microlenses 31, the exposed portion of the base material layer 10 is removed by etching using a dry etching process to form the microlens layer 30, and the remaining portion of the photoresist layer is then removed using a wet etching process.

The plurality of grooves 13 can be formed by a dry etching process or a wet etching process. Specifically, a photoresist layer is formed on the second surface 12 of the base material layer 10, a portion of the photoresist layer corresponding to the plurality of pattern units 21 is exposed, the exposed portion of the photoresist layer is removed using a developer to expose the portion of the second surface 12 of the base material layer 10 corresponding to the plurality of pattern units 21, and the exposed portion of the base material layer 10 is etched and removed using a dry etching or wet etching process to form the plurality of grooves 13.

The pattern layer 20 can be obtained by plating a metal film, such as a chromium film, or filling a color-developing material, such as ink, in the plurality of grooves 13 to form a plurality of pattern units 21, and then the remaining portion of the photoresist layer is removed using a dry etching or wet etching process.

The base material layer 10 can be a glass layer.

In other examples, a method for manufacturing the optical structure 100 can include the following steps: a microlens mold is prepared. The microlens layer 30 is formed on the first surface 11 of the base material layer 10 by the microlens mold. The second face 12 of the base material layer 10 is etched to form the plurality of grooves 13. And a plurality of pattern units 21 are formed in the plurality of grooves 13.

In other examples, a method for manufacturing the optical structure 100 can include the following steps: the first face 11 of the base material layer 10 is etched to form the microlens layer 30. A coating layer is formed on the second surface 12 of the base material layer 10. A photoresist layer is formed on a side of the coating layer far away from the base material layer 10. A portion of the photoresist layer corresponding to the outside of the plurality of pattern units 21, is removed, to expose a portion of the coating layer corresponding to the outside of the plurality of pattern units 21. The exposed portion of the coating layer is removed, and the portion of the coating layer corresponding to the plurality of pattern units 21 is reserved, to form the plurality of pattern units 21. The remaining portion of the photoresist layer is removed.

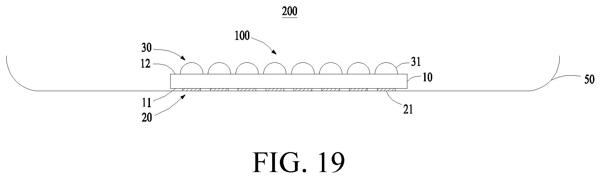

Referring to FIG. 19, FIG. 19 is a side view of a terminal shell 200 provided by the example of the present application. In some examples, as shown in FIG. 19, the terminal shell 200 includes an optical structure 100 provided by any of the foregoing examples.

In some examples, as shown in FIG. 19, the terminal shell 200 includes a transparent back cover 50 for covering the back surface of the terminal. The optical structure 100 is arranged on a side of the transparent back cover 50 close to the interior of the terminal, that is, on the inner surface of the transparent back cover 50. The pattern layer 20 of the optical structure 100 is bonded to the transparent back cover 50, and an optical adhesive can be arranged between the pattern layer 20 and the transparent back cover 50 to adhere the optical structure 100 to the inner surface of the transparent back cover 50.

Incident light enters from the transparent back cover 50 and reaches the microlens layer 30 through the pattern layer 20, and is reflected at the plurality of microlenses 31 to generate reflected light. The reflected light propagates to the pattern layer 20, and forms an image on the side of the pattern layer 20 far away from the base material layer 10, thereby forming the preset pattern with a three-dimensional suspension effect.

The transparent back cover 50 can be made of a transparent polymer or glass.

In some examples, the base material layer 10 is a glass layer. The terminal shell 200 is made of glass. The base material layer 10 is the transparent back cover 50 of the terminal shell 200.The microlens layer 30 is closer to the inside of the terminal than the pattern layer 20, that is, the pattern layer 20 is located on the outer surface. The terminal shell 200 can further include a protective layer arranged on a side of the pattern layer 20 far away from the microlens layer 30 to protect the pattern layer 20 from physical damage or chemical corrosion.

An example of the present application further provides a terminal. The terminal includes the terminal shell 200 described above. The terminal shell 200 is used to cover a back surface of the terminal, and the back surface of the terminal is opposite to a surface on which a screen of the terminal is located. The terminal can be an electronic device such as a mobile phone, a computer, a tablet, a wearable device, a display screen, or other types of electronic devices.

It should be noted that a person skilled in the art should recognize that the examples described in the specification are general examples, and the operations involved are not necessarily necessary for the present application.

The above is examples of the present application. It should be pointed out that for a person skilled in the art, some improvements and retouches can be made without departing from the principles of the examples of the present application, and these improvements and retouches are also regarded as the scope of protection of the present application.

## Claims

1. An optical structure 100, the optical structure 100 comprising:
a base material layer 10, comprising a first surface 11 and a second surface 12 opposite to each other;
a pattern layer 20, arranged on the first surface 11 of the base material layer 10, the pattern layer 20 comprising a plurality of pattern units 21 arranged in an array, each of the pattern units 21 being a portion of a preset pattern; and
a microlens layer 30, arranged on the second surface 12 of the base material layer 10, the microlens layer 30 comprising a plurality of microlenses 31 arranged in an array, each of the microlenses corresponding to one pattern unit, and the pattern unit 21 locating within the projection of the corresponding microlens 31 on the pattern layer 20, and the plurality of microlenses 31 being used to cause the plurality of pattern units 21 to form the preset pattern with a three-dimensional (3D) effect.

2. The optical structure 100 according to claim 1, wherein the preset pattern is a projection of a figure arranged on a three-dimensional structure on a plane, and projections of figures on the three-dimensional structure on the plane do not have an overlapping area.

3. The optical structure 100 according to claim 1 or 2, wherein a plurality of pattern units 21 in each row of pattern units satisfy a first preset condition, the first preset condition comprises a first combined pattern overlapping with a first sub-pattern of the corresponding preset pattern, the first combined pattern is formed by translating and combining the plurality of pattern units 21 in each row of pattern units in a first preset direction, the first sub-pattern is a partial pattern of the preset pattern extending a first preset distance in a second preset direction, and the second preset direction is perpendicular to the first preset direction; a plurality of pattern units 21 in each column of pattern units satisfy a second preset condition, the second preset condition comprises a second combined pattern overlapping with a second sub-pattern of the corresponding preset pattern, the second combined pattern is formed by translating and combining the plurality of pattern units 21 in each column of pattern units in a second preset direction, and the second sub-pattern is a partial pattern of the preset pattern extending a second preset distance in the first preset direction.

4. The optical structure 100 according to claim 3, wherein absolute values of the difference in the dimensions of every two adjacent pattern units 21 in each row of pattern units in a first preset direction are equal; absolute values of the difference in the dimensions of every two adjacent pattern units 21 in each column of pattern units in a second preset direction are equal.

5. The optical structure 100 according to claim 3 or 4, wherein two adjacent pattern units 21 in each row of pattern units are partially identical, the first preset condition comprises a first combined pattern overlapping with a corresponding first sub-pattern, and the first combined pattern is formed by combining the plurality of pattern units 21 in such a way that the identical portions overlap; two adjacent pattern units 21 in each column of pattern units are partially identical, the second preset condition comprises a second combined pattern overlapping with a corresponding second sub-pattern, and the second combined pattern is formed by combining the plurality of pattern units 21 in such a way that the identical portions overlap.

6. The optical structure 100 according to any one of claims 3 to 5, wherein a plurality of pattern units 21 in each row of pattern units are respectively portions cut from the corresponding first sub-pattern in a first preset direction; a plurality of pattern units 21 in each column of pattern units are respectively portions cut from the corresponding second sub-pattern in a second preset direction.

7. The optical structure 100 according to any one of claims 3 to 6, wherein the first and last pattern units 21 in each row of pattern units respectively comprise potions at both ends of the corresponding first sub-pattern in the first preset direction, the cut portions comprised in each row of pattern units, gradually increase from the first and last pattern units 21 to the middle pattern unit 21, and the cut portion comprised in the middle pattern unit 21, comprises at least the middle portion of the corresponding first sub-pattern; the first and last pattern units 21 in each column of pattern units respectively comprise potions at both ends of the corresponding second sub-pattern in the second preset direction, the cut portions comprised in each column of pattern units, gradually increases from the first and last pattern units 21 to the middle pattern unit 21, and the cut portion comprised in the middle pattern unit 21, comprises at least the middle portion of the corresponding second sub-pattern.

8. The optical structure 100 according to any one of claims 1 to 7, wherein the pattern layer 20 comprises a plurality of pattern regions 22 arranged in an array, each of the pattern regions 22 corresponds to one microlens 31, and the center of each of the pattern regions 22 is aligned with the center of the corresponding microlens 31, each of the pattern units 21 is arranged at a preset position in the corresponding pattern region 22, thereby each of the pattern units 21 corresponding to a preset portion of the corresponding microlens 31, and a corresponding pattern is formed through the corresponding microlens 31.

9. The optical structure 100 according to claim 8, wherein the shape of the pattern region 22 is the same as the shape of the projection of each of the microlenses 31 on the pattern layer 20.

10. The optical structure 100 according to claim 8, wherein the shape of the pattern region 22 is different from the shape of the projection of each of the microlenses 31 on the pattern layer 20.

11. The optical structure 100 according to any one of claims 1 to10, wherein the base material layer 10 comprises at least one of a transparent polymer layer and a glass layer.

12. The optical structure 100 according to any one of claims 1 to 11, wherein the base material layer 10 is a glass layer, the plurality of microlenses 31 are outwardly extending portions of glass of the glass layer, and/or a plurality of grooves 13 arranged in an array are arranged on the surface of the glass layer far away from the microlenses 31, each of the grooves 13 corresponds to one pattern unit and is covered by a corresponding pattern unit 21, and the shape of each of the grooves 13 is the same as the corresponding pattern unit 21.

13. The optical structure 100 according to any one of claims 1 to 12, wherein an outer contour of the microlens 31 is arc-shaped, the projection of the microlens 31 on the base material layer 10 is circular, and a diameter of the projection is a value in the range of 100-300 µm; a height of the microlens 31 is a value in the range of 0.1-20 µm, and the height of the microlens 31 is a distance between an end of the microlens 31 far away from the base material layer 10 and the base material layer 10.

14. The optical structure 100 according to any one of claims 1 to 13, wherein a thickness of the base material layer 10 is a value in the range of 0.1-0.6 mm, and the thickness of the base material layer 10 is the distance between the first surface 11 and the second surface 12.

15. The optical structure 100 according to any one of claims 1 to 14, wherein the pattern unit 21 can be formed of a metallic material, or a color-developing material.

16. A terminal shell 200, the terminal shell 200 comprising the optical structure 100 according to any one of claims 1 to 15.

17. The terminal shell 200 according to claim 16, wherein the terminal shell 200 comprises a transparent back cover 50, the optical structure 100 is arranged on a side of the transparent back cover 50 close to the interior of the terminal;
the pattern layer 20 of the optical structure 100 is bonded to the transparent back cover 50, and an optical adhesive can be arranged between the pattern layer 20 and the transparent back cover 50 to adhere the optical structure 100 to the inner surface of the transparent back cover 50.

18. The terminal shell 200 according to claim 17, wherein the preset pattern is formed by: incident light enters from the transparent back cover 50 and reaches the microlens layer 30 through the pattern layer 20, and is reflected at the plurality of microlenses 31 to generate reflected light, the reflected light propagates to the pattern layer 20, and forms an image on the side of the pattern layer 20 far away from the base material layer 10, thereby forming the preset pattern with a three-dimensional suspension effect.

19. The terminal shell 200 according to claim 17 or 18, wherein the transparent back cover 50 can be made of a transparent polymer or glass.

20. A terminal, the terminal comprising a terminal shell 200 according to any one of claims 16 to 19.
